# EUROPÄISCHE PATENTSCHRIFT

(11) **EP 2 624 677 B1**
(45) Veröffentlichungstag und Bekanntmachung des Hinweises auf die Patenterteilung: **22.08.2018**
(21) Anmeldenummer: 12193054.9
(22) Anmeldetag: 16.11.2012
(51) Int. Cl.: H05K 9/00, H01Q 1/24, H01Q 17/00

(54) **Gehäuse zur Aufnahme von elektrischen und/oder elektronischen Bauteilen**
Casing for the installation of electric or electronic components
Boîtier de réception de composants électriques et/ou électroniques

(30) Priorität: 02.02.2012 DE 102012100882
(43) Veröffentlichungstag der Anmeldung: 07.08.2013
(73) Patentinhaber: AESCULAP AG, 78532 Tuttlingen (DE)
(72) Erfinder: Schnekenburger, Rolf, 78532 Tuttlingen (DE); Schönewerk, Erik, 78166 Donaueschingen (DE); Schneider, Jürgen, 78532 Tuttlingen (DE)
(74) Vertreter: Winter, Brandl, Fürniss, Hübner, Röss, Kaiser, Polte - Partnerschaft mbB

(56) Entgegenhaltungen:
- EP-A1- 1 632 190
- EP-A2- 0 890 343
- EP-A2- 1 158 458
- DE-A1-102009 018 143
- US-A- 5 918 163
- US-A1- 2002 169 003
- US-A1- 2009 051 621

## Beschreibung

Die vorliegende Erfindung betrifft ein Gehäuse zur Aufnahme von elektrischen und/oder elektronischen Bauteilen, insbesondere ein Steuergehäuse mit eingebauter Steuerungselektronik, wobei das Gehäuse nach Art eines faraday'sehen Käfigs EMV-gesichert ist.

Als ein mögliches, die Erfindung in keiner Weise einschränkendes Beispiel eines derartigen Gehäuses sei ein Gehäuse betrachtet, welches auf dem Gebiet der Medizin bzw. der Chirurgie Anwendung findet und welches von der Anmelderin der vorliegenden Erfindung unter der Bezeichnung "Microspeed® Uni" vertrieben wird.

Dieses bekannte Gehäuse vereint eine Anzahl von Steuerungs- und Regelungsfunktionen in sich, wobei besagte Funktionen auf medizinische Geräte oder Werkzeuge angewendet werden, die für unterschiedliche medizinische, chirurgische oder kosmetische Anwendungen zum Einsatz gelangen. Die Geräte oder Werkzeuge werden über geräte- oder werkzeugseitige Stecker mit gehäuseseitigen Buchsen verbunden. Das Gehäuse selbst beziehungsweise die hierin aufgenommene Steuerungselektronik ist über eine mehrpolige Steckerverbindung und ein entsprechend mehrpoliges Kabel mit einem Fußschalter verbindbar, mit dem entsprechende Schalt- oder Funktionsanweisungen an die gehäuseseitige Steuerungselektronik ausgegeben werden können, welche dann wiederum in entsprechende Funktionen der medizinischen Geräte oder Werkzeuge umgesetzt werden. An der Frontseite des Gehäuses befindet sich darüber hinaus noch ein Display mit Touchbedienfeld, um separat von oder zusätzlich zu dem Fußschalter Steueranweisungen, Funktionsparameter etc. eingeben zu können.

Weiterhin befindet sich an der Frontseite des Gehäuses eine dort an- oder aufgesetzte Pumpe, insbesondere eine Rollen- oder Peristaltikpumpe, mit welcher eine Kühl- und/oder Spülflüssigkeit zum Operations- oder Behandlungsfeld gefördert werden kann, um ein dort laufendes Werkzeug zu kühlen, das Operationsfeld zu spülen etc. Die Ansteuerung der Pumpe erfolgt in der Regel über den erwähnten Fußschalter.

Da das Gehäuse elektrische und/oder elektronische Bauteile, also die Steuerungselektronik aufnimmt und mit der Pumpe eine Flüssigkeit, in der Regel Wasser gefördert wird, ist es aus sicherheitstechnischen Überlegungen unabdingbar, dass das Gehäuse, in welchem sich die Steuerungselektronik befindet und die Pumpe flüssigkeitsdicht voneinander abgegrenzt sind. Erreicht wird dies dadurch, dass die Pumpe bzw. das die Pumpe kapselnde Gehäuse an die Vorderseite des eigentlichen Steuerungsgehäuses angesetzt wird.

Darüber hinaus muss das Gehäuse EMV-dicht ausgeführt werden, also nach Art eines faraday'schen Käfigs wirken, um betriebssicher arbeiten zu können.

In letzter Zeit hat sich die Forderung nach einer draht- oder kabellosen Ansteuerungsmöglichkeit der gehäuseseitigen Steuerungselektronik ergeben, das heißt, die Verbindung zwischen dem Fußschalter und dem Gehäuse soll nicht mehr über das mehradrige Kabel sondern drahtlos über eine entsprechende Nahbereichs-Funktechnik erfolgen. Aufgrund der EMV-dichten oder EMV-gesicherten Ausführung des Gehäuses macht dies die Anordnung einer Sende- und/oder Empfangsvorrichtung außerhalb der Gehäuseabschirmung notwendig, damit die drahtlos übermittelten Befehle von dem Fußschalter empfangen werden können. Eine derartige, außerhalb des Gehäuses bzw. der Gehäuseabschirmung liegende Sende- und/oder Empfangsvorrichtung ist jedoch insofern nachteilig oder problematisch, als sie einen störenden An- oder Aufbau am Gehäuse darstellt, der in störender oder unschöner Art und Weise von der Außenkontur des Gehäuses vorsteht. Darüber hinaus kann ein derartiger An- oder Aufbau in nachteiliger Weise ein Aneinanderreihen oder Übereinanderstapeln mehrerer Steuerungsgehäuse oder deren Einschub in ein Rack be- oder verhindern.

Gleichermaßen verhält es sich mit der an der Gehäusefront anbringbaren Pumpe: Sie steht in nicht unerheblichen Maß von der Fläche der Gehäusefront vor und ist insofern sowohl ästhetisch als auch in der Praxis, das heißt im Betrieb störend, als es sich um ein vorstehendes Hindernis handelt, welches naturgemäß berührungsempfindlich ist, an welchem sich Gegenstände oder vorbeigehende Personen verfangen können etc.

Die Erfindung hat es sich demgegenüber zur Aufgabe gemacht, ein Gehäuse der in Frage stehenden Art derart auszugestalten, dass im praktischen Betrieb eine hohe Funktionalität und Sicherheit erreicht wird, wobei insbesondere ein uneingeschränkter drahtloser Kommunikationsweg zwischen der gehäuseseitigen Steuerungselektronik und einer externen Steuereinrichtung sichergestellt sein soll, ohne dass an dem Gehäuse unfallträchtige oder im Praxisbetrieb unpraktische An- oder Aufbauten vorhanden sein müssen.

Zur Lösung dieser Aufgabe schlägt die vorliegende Erfindung ein Gehäuse für medizinische Zwecke vor, bei dem in wenigstens einer Gehäuseseitenwand wenigstens ein zur Gehäuseaußenseite hin offener und ansonsten allseitig im Wesentlichen geschlossener Aufnahmeraum ausgebildet ist, dessen Begrenzungswände EMV-gesichert ausgeführt sind. Weiterhin ist in dem Aufnahmeraum wenigstens ein EMV-ungesicherter Übertrager in Form einer EMV-ungesicherten Sende- und/oder Empfangsvorrichtung angeordnet welche eine drahtlose Kommunikation zwischen der gehäuseseitigen Steuerungselektronik und einer externen Steuereinrichtung herzustellen vermag und weiterhin ist eine von der gehäuseseitigen Steuerungselektronik ansteuerbare funktionelle Komponente in dem EMV-gesicherten Aufnahmeraum angeordnet. Die von der gehäuseseitigen Steuerungselektronik ansteuerbare funktionelle Komponente, welche gemäß der vorliegenden Erfindung eine (medizinische) Pumpe, insbesondere eine Peristaltikpumpe ist wird daher von der Gehäusefrontplatte, von der sie bislang um einen der Bautiefe der Pumpe oder des Pumpengehäuses entsprechenden Betrag vorstand, in den Aufnahmeraum verlagert, sodass idealerweise die funktionelle Komponente in dem Aufnahmeraum derart zu liegen kommt, dass die sichtbare Vorderseite der Komponente und die Gehäuseseitenwand, in der der Aufnahmeraum ausgebildet ist, im Wesentlichen eine Ebene bilden. Dadurch, dass die Begrenzungswände des Aufnahmeraums ebenfalls EMV-gesichert ausgeführt sind, erfolgt durch die Ausbildung des Aufnahmeraums in der wenigstens einen Gehäuseseitenwand keine Durchbrechung der EMV-Abschirmung des gesamten Gehäuses, sodass die Betriebssicherheit weiterhin gewährleistet ist. Da weiterhin der EMV-ungesicherte Übertrager in Form der Sende- und/oder Empfangsvorrichtung ebenfalls in dem Aufnahmeraum angeordnet ist, befindet sich der Übertrager einerseits außerhalb des EMV-gesicherten oder abgeschirmten Gehäuses, kann also eine uneingeschränkte Nahbereichs-Kommunikation mit der externen Steuereinrichtung durchführen, andererseits ist der Übertrager durch die Anordnung im Bereich des Aufnahmeraums von der Außenhülle des Gehäuses wegverlagert, stellt also keine störende Einheit an der Gehäuseaußenwand dar. Da schließlich der Aufnahmeraum durch seine Begrenzungswände allseitig im Wesentlichen geschlossen ist (mit Ausnahme der zur Gehäuseaußenseite hin weisenden Öffnung), ist die Betriebssicherheit trotz der Aufnahme der flüssigkeitsführenden Pumpe quasi im Inneren des Gehäuses uneingeschränkt gegeben.

Vorteilhafte Weiterbildungen und Ausgestaltungen der Erfindung sind Gegenstand der Unteransprüche.

Gemäß einer bevorzugten Ausgestaltungsform ist der EMV-ungesicherte Übertrager eine Antenne, beispielsweise eine Bluetooth®-Antenne zur Durchführung der drahtlosen Kommunikation zwischen der gehäuseseitigen Steuerungselektronik und der externen Steuereinrichtung, beispielsweise des Fußschalters oder der Fußschalter.

Eine mögliche Ausführungsform der vorliegenden Erfindung schlägt vor, dass der Übertrager (die Antenne) und die von der gehäuseseitigen Steuerungselektronik ansteuerbare funktionelle Komponente (z. B. die Pumpe) zu einer Einheit zusammengefasst sind. Der Übertrager bzw. die Antenne befindet sich somit im Inneren der funktionellen Komponente, ist also quasi von dieser gekapselt oder eingehaust und zusätzlich geschützt.

In einer anderen Ausgestaltungsform kann der Übertrager in einem Zwischenraum zwischen der funktionellen Komponente und den Begrenzungswänden des Aufnahmeraums angeordnet sein. Der Übertrager (die Antenne) ist somit aus der funktionellen Komponente herausgeführt, also ein dem Gehäuse zugeordnetes Bauteil, welches bei Entnahme der Komponente aus dem Aufnahmeraum in diesem verbleibt.

Der Übertrager kann mit der gehäuseseitigen Steuerungselektronik über wenigstens eine abgeschirmte Kabelverbindung kommunizieren, wobei die abgeschirmte Kabelverbindung wenigstens ein Signalkabel und/oder wenigstens ein Energieversorgungskabel aufweist. Zwar ist es bei einer abgeschirmten Kabelverbindung unumgänglich, das oder die Kabel durch die Gehäusewand und damit durch die EMV-Abschirmung zu führen, jedoch ist die hierfür notwendige Durchtrittsöffnung in der EMV-Abschirmung bezogen auf die gesamte Abschirmungsfläche vernachlässigbar klein, sodass keinerlei Nachteile hieraus erwachsen.

Die abgeschirmte Kabelverbindung kann weiterhin wenigstens eine lösbare Steckverbindung aufweisen. Dies erleichtert die Entnahme der Komponente aus dem Aufnahmeraum und insbesondere den Austausch verschiedener Komponenten untereinander, da hierzu lediglich die Steckverbindung gelöst werden muss.

Die lösbare Steckverbindung kann weiterhin wenigstens einen Steckverbinder seitens der funktionellen Komponente und wenigstens einen komplementären Gegensteckverbinder z.B. seitens der Bodenwand des Aufnahmeraums aufweisen, wobei Steckverbinder und Gegensteckverbinder beim Einsetzen der funktionellen Komponente in den Aufnahmeraum miteinander kontaktieren. Dieses Verbindungsprinzip, welches an sich von Einschubgehäusen oder Racks bekannt ist, stellt eine besonders bevorzugte Ausgestaltungsform der Steckverbindung dar.

Wie bereits weiter oben erläutert, kann gemäß einer Ausgestaltungsform die funktionelle Komponente eine Pumpe, insbesondere eine Peristaltikpumpe sein. Es versteht sich jedoch, dass der Gegenstand der vorliegenden Erfindung nicht hierauf beschränkt ist.

Insbesondere aus sicherheitstechnischen Gründen, jedoch auch aufgrund ästhetischer Überlegungen kann es vorteilhaft sein, den Aufnahmeraum bei eingesetzter funktioneller Komponente, beispielsweise bei eingesetzter Pumpe, durch eine Blende zumindest teilweise zu verschließen. Unter "Blende" sei hierbei ein beliebiges Verschlusselement verstanden, mit welchem die Öffnung des Aufnahmeraums zumindest teilweise verschließbar ist, also beispielsweise eine Klappe, ein Rollverschluss, ein Schieber oder dergleichen.

Weitere Einzelheiten, Aspekte und Vorteile der vorliegenden Erfindung ergeben sich besser aus der nachfolgenden Beschreibung von Ausführungsformen anhand der Zeichnung.

Es zeigt:
Figur 1 eine schematisch vereinfachte perspektivische Ansicht eines erfindungsgemäßen Gehäuses und einer in dem Gehäuse anordenbaren funktionellen Komponente;
Figur 2 eine stark vereinfachte Seitenschnittansicht durch das erfindungsgemäße Gehäuse gemäß einer Ausführungsform; und
Figur 3 eine Figur 2 entsprechende Ansicht einer weiteren Ausführungsform.

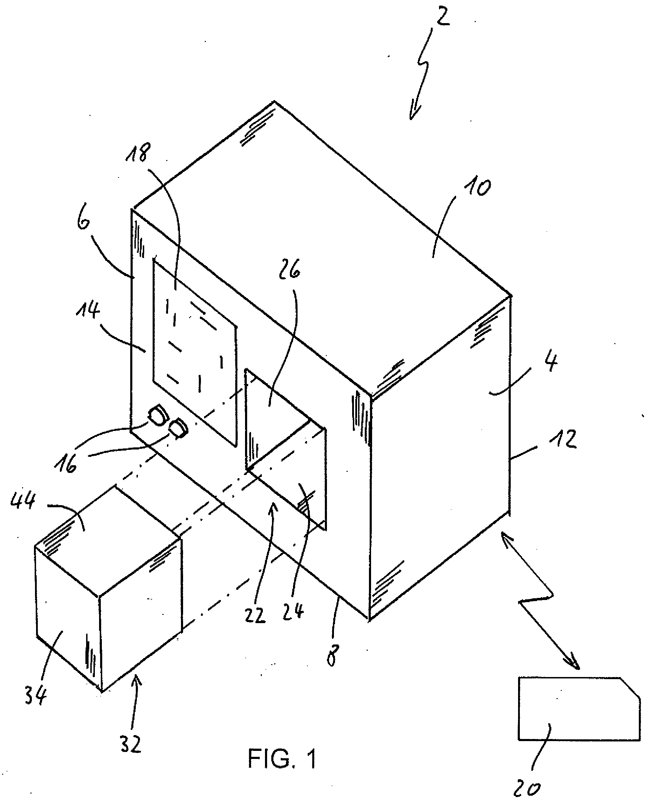

Eine in der Zeichnung insgesamt mit 2 bezeichnetes Gehäuse hat den in Figur 1 dargestellten schachtel- oder boxartigen Aufbau in Form eines Parallelflächers mit zwei Seitenwänden 2 und 4, einer Bodenwand 8, einer Deckenwand 10, einer Rückwand 12 und einer Vorderwand 14.

Größe und Form des Gehäuses 2 sind den jeweiligen Anwendungsfällen oder Einsatzzwecken entsprechend gestaltet, das heißt die in Figur 1 dargestellte Form des Gehäuses 2 ist rein beispielhaft und nicht einschränkend.

Das Gehäuse 2 dient zur Aufnahme von in der Zeichnung nicht näher dargestellten elektrischen und/oder elektronischen Bauteilen und ist insbesondere ein Steuerungsgehäuse mit einer eingebauten Steuerungselektronik, wobei das Gehäuse nach Art eines faraday'schen Käfigs EMV-gesichert ist. Die notwendigen technischen Maßnahmen zur EMV-Abschirmung von Gehäusen sind technisches Allgemeingut, sodass nicht näher hierauf eingegangen wird.

Das Gehäuse 2 sei im dargestellten Ausführungsbeispiel ein Steuerungsgehäuse für medizinische oder chirurgische Zwecke, sodass die gehäuseseitige Steuerungselektronik zur Versorgung und Ansteuerung entsprechender Behandlungsgeräte oder Behandlungsinstrumente dient. Besagte Geräte oder Instrumente können über entsprechende Buchsen 16 oder ähnliche Steckverbindungen, welche an der Vorderwand 14 vorhanden sind, angeschlossen werden. Ebenfalls befindet sich in der Vorderwand 14 ein Bedienungs- und/oder Anzeigefeld 18, mit welchem bestimmte Einstellungen, Funktionsparameter etc. einstellbar, überwachbar oder abrufbar sind.

Eine externe Steuereinrichtung 20 ist insbesondere, jedoch nicht ausschließlich in Form einer Fußsteuerung oder eines Fußschalters ausgelegt und enthält wenigstens ein fußbetätigtes Pedal, um die gehäuseseitige Steuerungselektronik mit Befehlen oder Informationen zu beaufschlagen, welche dann - gegebenenfalls einer entsprechenden Programmierung folgend - in Anweisungen oder Steuerungsbefehle umgesetzt werden, welche über die Buchsen 16 ausgegeben werden.

Die externe Steuereinrichtung 20 kommuniziert mit der gehäuseseitigen Steuerungselektronik drahtlos mittels einer Nahbereichskommunikation, beispielsweise Bluetooth®, wie in Figur 1 schematisch durch die Pfeile dargestellt. Dies bedeutet, dass zwischen der Steuereinrichtung 20 und dem Gehäuse 2 kein Kabel zur uni- oder bidirektionalen Signalübertragung verläuft.

Das Gehäuse 2 weist in wenigstens einer seiner Seitenwände, im dargestellten Ausführungsbeispiel in der Vorderwand 14, wenigstens eine Öffnung auf, hinter der in dem Gehäuse 2 ein Aufnahmeraum 22 in das Gehäuseinnere hinein ausgebildet ist. Der Aufnahmeraum 22 ist mit Ausnahme der Öffnung in der Vorderwand 14 im Wesentlichen allseitig geschlossen ausgebildet und weist demzufolge die in der Zeichnung dargestellten bzw. sichtbaren Begrenzungswände 24, 26 und 28, sowie eine Bodenwand 30 auf. Der Begrenzungswand 24 liegt die Begrenzungswand 28 gegenüber und der Begrenzungswand 26 eine in keiner der Figuren sichtbare Begrenzungswand.

Der Aufnahmeraum 22 dient ausweislich Figur 1 zur Aufnahme einer funktionellen Komponente 32, welche gemäß den Figuren eine äußere Formgebung hat, welche an diejenige des Aufnahmeraums 22 angepasst ist (wobei in der Praxis die Situation überwiegen dürfte, dass der Aufnahmeraum 22 an die Außenkontur der Komponente 32 anzupassen ist; insofern ist die zeichnerische Darstellung sowohl des Aufnahmeraums 22 als auch der Komponente 32 als rein exemplarisch bzw. schematisch veranschaulichend zu verstehen).

Die funktionelle Komponente 32 ist eine Funktionseinheit oder ein Funktionsblock, welcher unter Steuerung der gehäuseseitigen Steuerungselektronik, welche wiederum von der externen Steuereinrichtung 20 befehligt wird, bestimmte Funktionen ausführt. Ein konkretes und nicht einschränkendes Beispiel für die funktionelle Komponente 32 sei eine Flüssigkeitspumpe, beispielsweise eine Rollen- oder Peristaltikpumpe, mit der Kühl- oder Spülflüssigkeit förderbar ist. Andere Beispiele für die funktionelle Komponente 32 wären beispielsweise Drucklufterzeuger, Absaugvorrichtungen oder dergleichen.

Um die EMV-Sicherung oder EMV-Kapselung des Gehäuses 2 durch den Aufnahmeraum 22 nicht zu unterbrechen, sind sämtliche den Aufnahmeraum 22 begrenzenden Wände (Seitenwände 24, 26, 28 und die der Wand 26 gegenüberliegende Wand, sowie Bodenwand 30) ebenfalls EMV-gesichert ausgeführt.

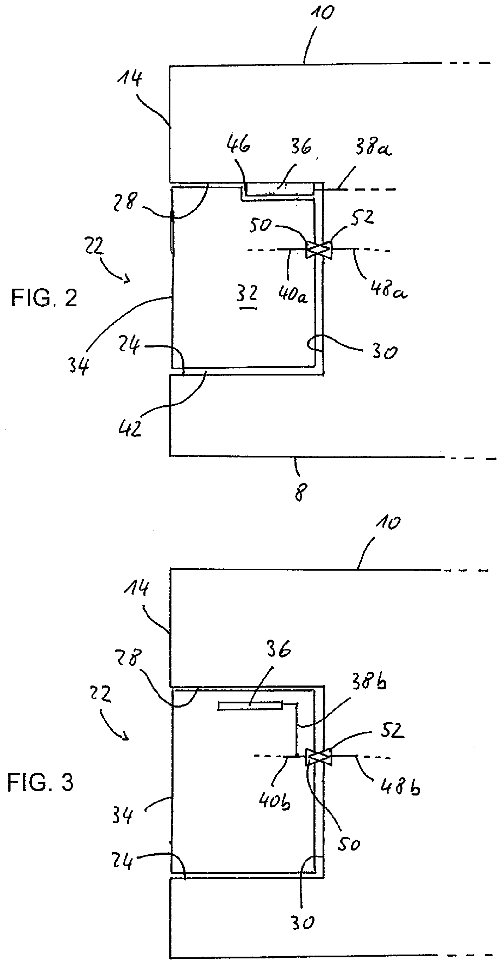

Die Figuren 2 und 3 zeigen in vereinfachter seitlicher Schnittdarstellung, wie die funktionelle Komponente 32 in den Aufnahmeraum 22 eingeschoben ist. Die Tiefe der Komponente 32 sowie des Aufnahmeraums 22 ist bevorzugt derart ausgelegt, dass ausweislich der Figuren 2 und 3 eine Vorderfläche 34 der Komponente 32 mit der Vorderwand 14 des Gehäuses 2 im Wesentlichen in einer Ebene liegt, wenn die Komponente 32 in dem Aufnahmeraum 22 aufgenommen ist. Mit anderen Worten, die Komponente 32 steht nicht oder nur unwesentlich von der Ebene der Vorderwand 14 vor.

Die bündige oder im wesentlichen bündige Aufnahme der Komponente 32 im Aufnahmeraum 22 erlaubt, dass Insbesondere aus sicherheitstechnischen Gründen, jedoch auch aufgrund ästhetischer Überlegungen, den Aufnahmeraum 22 bei eingesetzter Komponente 32 durch eine in der Zeichnung nicht näher dargestellte Blende zumindest teilweise zu verschließen. Unter "Blende" sei hierbei ein beliebiges Verschlusselement verstanden, mit welchem die Öffnung des Aufnahmeraums 22 zumindest teilweise verschließbar ist, also beispielsweise eine Klappe, ein Rollverschluss, ein Schieber oder dergleichen.

Um trotz der EMV-gesicherten Ausführung des Gehäuses 2 (und des Aufnahmeraums 22) eine drahtlose Kommunikation zwischen der externen Steuereinrichtung und der gehäuseseitigen Steuerungselektronik zu ermöglichen, ist seitens des Gehäuses 2 ein EMV-ungesicherter Übertrager in Form einer EMV-ungesicherten Sende- und/oder Empfangsvorrichtung vorgesehen. Dieser Übertrager ist in den Figuren 2 und 3 mit den Bezugszeichen 36 veranschaulicht. Der Übertrager 36 kann beispielsweise als Sende/Empfangsantenne (Transceiver) ausgebildet sein und steht mit der gehäuseseitigen Steuerungselektronik über eine ein- oder mehradrige Leitung 38a (Figur 2) oder 38b (Figur 3) in Verbindung. Weiterhin stehen Bauteile, Antriebe etc. im Inneren der Komponente 32 über ein Kabel 40a (Figur 2) oder ein Kabel 40b (Figur 3) mit der gehäuseseitigen Steuerungselektronik und/oder einem dortigen Netzteil etc. in Verbindung.

In dem Ausführungsbeispiel von Figur 2 befindet sich der Übertrager oder die Antenne 36 in einem Zwischenraum 42 zwischen dem Außenumfang der Komponente 32 und dem Aufnahmeraum 22, das heißt z.B. zwischen der Begrenzungswand 28 und einer Oberseite 44 der Komponente 32. Der Übertrager 36 kann hierbei an der Begrenzungswand 28 festgelegt sein und die Oberseite 44 der Komponente 32 weist eine entsprechende Ausnehmung oder Vertiefung 46 auf, welche in Form, Größe und Verlauf an den Übertrager 36 angepasst ist und trotz des sich an der Begrenzungswand 28 befindlichen Übertragers 36 ein ungehindertes Einschieben oder Herausziehen der Komponente 32 in oder aus dem Aufnahmeraum 22 gestattet.

Das Kabel oder die Leitung 38a ist ausgehend vom Übertrager 36 durch eine entsprechende Öffnung in der Bodenwand 30 zu der gehäuseseitigen Steuerungselektronik gelegt. Die Leitung 38 durchtritt hierbei die Bodenwand 30 in einer entsprechenden Öffnung.

Im Ausführungsbeispiel von Figur 3 befindet sich der Übertrager 36 im Inneren der Komponente 32, wobei der Übertrager 36 dann beispielsweise auch spezifisch für die jeweilige Komponente 32 ausgelegt sein kann.

Gemäß Figur 2 endet bevorzugt das Kabel oder die Leitung 40a, welche aus der Komponente 32 herausführt, in einem Steckverbinder 50, der in einen entsprechenden Gegensteckverbinder 52 einführbar ist, wenn die Komponente 32 vollständig in dem Aufnahmeraum 22 aufgenommen ist. Eine vom Gegensteckverbinder 52 ausgehende Leitung 48a führt dann zu der gehäuseseitigen Steuerungselektronik, einer gehäuseseitigen Energieversorgung etc.

Im Ausführungsbeispiel von Figur 3 ist die vom Übertrager 36 ausgehende Leitung 38b auf die komponentenseitige Leitung 40b geführt und geht dann über den Steckverbinder 50 und den Gegensteckverbinder 52 zu der gehäuseseitigen Leitung 48b.

Dadurch, dass der Übertrager (die Antenne) 36 in beiden Ausführungsbeispielen außerhalb der EMV-Abschirmung des Gehäuses 2 liegt, ist eine ungehinderte Kommunikation zwischen der externen Steuereinrichtung 20 und der gehäuseseitigen Steuerungselektronik gewährleistet. Darüber hinaus ist der Übertrager 36 in dem Aufnahmeraum 22 bzw. in der Komponente 32 quasi unsichtbar und geschützt, das heißt, er trägt weder an einer der Außenflächen des Gehäuses 2 in irgendeiner Weise auf, noch ist er der Gefahr von Verbiegen, Bruch oder dergleichen ausgesetzt. Die Außenflächen des Gehäuses 2 und hier insbesondere die beiden Seitenwände 2 und 4 und die Bodenwand 8 und die Deckenwand 10 können glatt, das heißt ohne Vorsprünge ausgebildet werden, sodass auch eine Mehrzahl erfindungsgemäß ausgebildeter Gehäuse 2 neben- und/oder übereinanderstapelbar ist. Auch ist der Einschub des Gehäuses 2 in einen Geräteträger oder ein Rack nicht durch irgendwelche vorstehenden Antennenelemente oder dergleichen behindert.

Dadurch, dass die Begrenzungswände des Aufnahmeraums 22 im Wesentlichen geschlossen sind (mit Ausnahme der Durchführung der Leitung 38a in Figur 2, sowie des Gegensteckverbinders 52 in den Figuren 2 und 3, wobei diese Durchführungen ohne weiteres auch fluiddicht ausgelegt werden können), besteht keine Gefahr, dass dann, wenn die Komponente 32 eine Fluid Förderpumpe oder Fluid Absaugpumpe ist, das jeweils in Frage stehende Fluid in das Innere des Gehäuses 2 gelangen kann.

Es versteht sich, dass im Rahmen der vorliegenden Erfindung noch weitere Modifikationen oder Abwandlungen denkbar sind. So ist beispielsweise die Anzahl der Aufnahmeräume nicht auf die Figur 1 dargestellte Einzelzahl beschränkt, sondern es können auch mehrere derartiger Aufnahmeräume nicht nur in der Vorderwand 14, sondern auch in den übrigen Außenwänden des Gehäuses 2 vorgesehen werden. Auch müssen die Aufnahmeräume 22 nicht von gleicher Größe und/oder gleicher Form sein.

Ist - wie weiter oben bereits ausgeführt - die funktionelle Komponente 32 eine Fluidförderpumpe oder Fluidabsaugpumpe oder ein anderes mechanisch angetriebenes Element, kann zusätzlich zu der Leitung 38a und/oder der Leitung 48a (48b) ein mechanischer Antrieb durch die Bodenwand 30 geführt werden, beispielsweise eine Antriebswelle mit einem Kupplungselement am freien Ende, welches dann mit einem entsprechenden Gegenkupplungselement seitens der Komponente 32 in Eingriff gelangt, wenn die Komponente 32 in den Aufnahmeraum 22 eingeschoben worden ist. Die Durchführung der Antriebswelle durch die Bodenwand 30 ist bevorzugt fluiddicht ausgelegt.

Beschrieben wurde insoweit zusammenfassend ein Gehäuse zur Aufnahme von elektrischen und/oder elektronischen Bauteilen, insbesondere jedoch nicht ausschließlich ein Steuerungsgehäuse mit eingebauter Steuerungselektronik, wobei das Gehäuse nach Art eines Faraday'schen Käfigs EMV-gesichert ist. In wenigstens einer Gehäuseaußenwand ist wenigstens ein zur Gehäuseaußenseite hin offener und ansonsten allseitig im wesentlichen geschlossener Aufnahmeraum ausgebildet, dessen Begrenzungswände ebenfalls EMV-gesichert ausgeführt sind. In dem Aufnahmeraum sind wenigstens ein EMV-ungesicherter Übertrager in Form einer EMV-ungesicherten Sende- und/oder Empfangsvorrichtung, welche eine drahtlose Kommunikation zwischen der gehäuseseitigen Steuerungselektronik und einer externen Steuereinrichtung herzustellen vermag und eine von der gehäuseseitigen Steuerungselektronik ansteuerbare funktionelle Komponente anordenbar. Der Übertrager ist bevorzugt eine Antenne, wobei deren Anordnung in dem Aufnahmeraum sicherstellt, dass sie außerhalb der EMV-Absicherung oder -Abschirmung liegt. Die funktionelle Komponente eine Pumpe, insbesondere eine Peristaltikpumpe ist welche durch die Anordnung in dem Aufnahmeraum geschützt ist und nicht störend vom Gehäuse vorragt.

## Patentansprüche

1. Gehäuse einer medizinischen Vorrichtung zur Aufnahme von elektrischen und/oder elektronischen Bauteilen, insbesondere medizinisches Steuerungsgehäuse mit eingebauter Steuerungselektronik, wobei das Gehäuse (2) nach Art eines Faraday'schen Käfigs EMV-gesichert ist, wobei
in wenigstens einer Gehäuseaußenwand (14) wenigstens ein zur Gehäuseaußenseite hin offener und ansonsten allseitig im wesentlichen geschlossener Aufnahmeraum (22) ausgebildet ist, dessen Begrenzungswände (24, 26, 28, 30) ebenfalls EMV-gesichert ausgeführt sind; und
in dem Aufnahmeraum (22) wenigstens ein EMV-ungesicherter Übertrager (36) in Form einer EMV-ungesicherten Sende- und/oder Empfangsvorrichtung, welche eine drahtlose Kommunikation zwischen der gehäuseseitigen Steuerungselektronik und einer externen Steuereinrichtung (20) herzustellen vermag, und eine von der gehäuseseitigen Steuerungselektronik ansteuerbare funktionelle Komponente (32) angeordnet sind, **dadurch gekennzeichnet, dass** die funktionelle Komponente (32) eine Pumpe, insbesondere eine Peristaltikpumpe ist.

2. Gehäuse nach Anspruch 1, **dadurch gekennzeichnet, dass** der Übertrager (36) eine Antenne ist.

3. Gehäuse nach Anspruch 1 oder 2, **dadurch gekennzeichnet, dass** der Übertrager (36) und die von der gehäuseseitigen Steuerungselektronik ansteuerbare funktionelle Komponente (32) zu einer Einheit zusammengefasst sind.

4. Gehäuse nach Anspruch 1 oder 2, **dadurch gekennzeichnet, dass** der Übertrager (36) aus der funktionellen Komponente (32) herausgeführt und in einem Zwischenraum (42) zwischen der funktionellen Komponente (32) und den Begrenzungswänden (24, 26, 28, 30) des Aufnahmeraums (22) angeordnet ist.

5. Gehäuse nach einem der Ansprüche 1 bis 4, **dadurch gekennzeichnet, dass** der Übertrager (36) mit der gehäuseseitigen Steuerungselektronik über wenigstens eine abgeschirmte Kabelverbindung (38a, 38b) kommuniziert.

6. Gehäuse nach Anspruch 5, **dadurch gekennzeichnet, dass** die abgeschirmte Kabelverbindung (38a, 38b) wenigstens ein Signalkabel und/oder wenigstens ein Energieversorgungskabel aufweist.

7. Gehäuse nach Anspruch 5 oder 6, **dadurch gekennzeichnet, dass** die abgeschirmte Kabelverbindung (38a, 38b) wenigstens eine lösbare Steckverbindung aufweist.

8. Gehäuse nach Anspruch 7, **dadurch gekennzeichnet, dass** die lösbare Steckverbindung wenigstens einen Steckverbinder (50) seitens der funktionellen Komponente (32) und wenigstens einen komplementären Gegensteckverbinder (52) seitens einer Begrenzungswand, insbesondere einer Bodenwand (30) des Aufnahmeraums (22) aufweist, wobei Steckverbinder (50) und Gegensteckverbinder (52) beim Einsetzen der funktionellen Komponente (32) in den Aufnahmeraum (22) miteinander kontaktieren.

9. Gehäuse nach einem der vorhergehenden Ansprüche, **dadurch gekennzeichnet, dass** der Aufnahmeraum (22) bei eingesetzter funktioneller Komponente (32) durch eine Blende zumindest teilweise verschließbar ist.

## Claims

1. Housing of a medical device for accommodating electric and/or electronic components, especially medical control housing having incorporated control electronics, the housing (2) being EMC safe in the manner of a Faraday cage, wherein
in at least one housing outer wall (14) at least one accommodating chamber (22) open toward the outside of the housing and otherwise substantially closed to all sides is formed whose limiting walls (24, 26, 28, 30) are configured to be equally EMC safe; and
in the accommodating chamber (22) at least one non-EMC safe transmitter (36) in the form of a non-EMC safe transmitting and/or receiving device adapted to provide wireless communication between the housing-side control electronics and an external control device (20), and a functional component (32) adapted to be controlled by the housing-side control electronics are arranged,
**characterized in that** the functional component (32) is a pump, especially a peristaltic-type pump.

2. The housing according to claim 1, **characterized in that** the transmitter (36) is an antenna.

3. The housing according to claim 1 or 2, **characterized in that** the transmitter (36) and the functional component (32) adapted to be controlled by the housing-side control electronics are combined to form a unit.

4. The housing according to claim 1 or 2, **characterized in that** the transmitter (36) is guided out of the functional component (32) and arranged in a clearance (42) between the functional component (32) and the limiting walls (24, 26, 28, 30) of the accommodating chamber (22).

5. The housing according to any one of the claims 1 to 4, **characterized in that** the transmitter (36) communicates with the housing-side control electronics via at least one shielded cable connection (38a, 38b).

6. The housing according to claim 5, **characterized in that** the shielded cable connection (38a, 38b) includes at least one signal cable and/or at least one power supply cable.

7. The housing according to claim 5 or 6, **characterized in that** the shielded cable connection (38a, 38b) has at least one releasable plug connection.

8. The housing according to claim 7, **characterized in that** the releasable plug connection includes at least one plug connector (50) on the side of the functional component (32) and at least one complementary mating plug connector (52) on the side of a limiting wall, especially a bottom wall (30) of the accommodating chamber (22), the plug connector (50) and the mating plug connector (52) contacting each other upon insertion of the functional component (32) into the accommodating chamber (22).

9. The housing according to any one of the preceding claims, **characterized in that** the accommodating chamber (22) is at least partially closable by a diaphragm when the functional component (32) is inserted.

## Revendications

1. Boîtier d'un dispositif médical servant à recevoir des composants électriques et/ou électroniques, en particulier boîtier de commande médical avec une électronique de commande intégrée, dans lequel le boîtier (2) est protégé par une technologie CEM à la manière d'une cage de Faraday, dans lequel
est réalisé dans au moins une paroi extérieure de boîtier (14) au moins un espace de logement (22) ouvert en direction du côté extérieur de boîtier et par ailleurs sensiblement fermé de tous les côtés, dont les parois de délimitation (24, 26, 28, 30) sont réalisées également avec une protection par une technologie CEM ; et
sont disposés, dans l'espace de logement (22), au moins un système de transmission (36) non protégé par une technologie CEM se présentant sous la forme d'un dispositif d'émission et/ou de réception non protégé par une technologie CEM, qui est en mesure d'établir une communication sans fil entre l'électronique de commande côté boîtier et un système de commande externe (20), et une composante fonctionnelle (32) pouvant être pilotée par l'électronique de commande côté boîtier, **caractérisé en ce que** la composante fonctionnelle (32) est une pompe, en particulier une pompe péristaltique.

2. Boîtier selon la revendication 1, **caractérisé en ce que** le système de transmission (36) est une antenne.

3. Boîtier selon la revendication 1 ou 2, **caractérisé en ce que** le système de transmission (36) et la composante fonctionnelle (32) pouvant être pilotée par l'électronique de commande côté boîtier sont regroupés en une unité.

4. Boîtier selon la revendication 1 ou 2, **caractérisé en ce que** le système de transmission (36) est sorti de la composante fonctionnelle (32) et est disposé dans un espace intermédiaire (42) entre la composante fonctionnelle (32) et les parois de délimitation (24, 26, 28, 30) de l'espace de logement (22).

5. Boîtier selon l'une quelconque des revendications 1 à 4, **caractérisé en ce que** le système de transmission (36) communique avec l'électronique de commande côté boîtier par l'intermédiaire d'au moins une liaison par câble blindée (38a, 38b).

6. Boîtier selon la revendication 5, **caractérisé en ce que** la liaison par câble blindée (38a, 38b) présente au moins un câble de signal et/ou au moins un câble d'alimentation en énergie.

7. Boîtier selon la revendication 5 ou 6, **caractérisé en ce que** la liaison par câble blindée (38a, 38b) présente au moins un système de connexion enfichable amovible.

8. Boîtier selon la revendication 7, **caractérisé en ce que** le système de connexion enfichable amovible présente au moins un connecteur enfichable (50) du côté de la composante fonctionnelle (32) et au moins un contre-connecteur enfichable (52) complémentaire du côté d'une paroi de délimitation, en particulier d'une paroi de fond (30) de l'espace de logement (22), dans lequel le connecteur enfichable (50) et le contre-connecteur enfichable (52) établissent un contact l'un avec l'autre lors de l'insertion de la composante fonctionnelle (32) dans l'espace de logement (22).

9. Boîtier selon l'une quelconque des revendications précédentes, **caractérisé en ce que** l'espace de logement (22) peut être fermé au moins en partie par un diaphragme lorsque la composante fonctionnelle (32) est insérée.
